# EUROPÄISCHE PATENTANMELDUNG

(11) **EP 0 961 314 A1**
(43) Veröffentlichungstag der Anmeldung: **01.12.1999**
(21) Anmeldenummer: 99108695.0
(22) Anmeldetag: 19.05.1999
(51) Int. Cl.: H01L 21/304, H01L 21/302

(54) **Hochebene Halbleiterscheibe aus Silicium und Verfahren zur Herstellung von Halbleiterscheiben**

(30) Priorität: 28.05.1998 DE 19823904
(71) Anmelder: Wacker Siltronic Gesellschaft für Halbleitermaterialien Aktiengesellschaft, 84489 Burghausen (DE)
(72) Erfinder: Wenski, Guido, Dr., 84489 Burghausen (DE); Passer, Bernd, 84489 Burghausen (DE)
(74) Vertreter: Rimböck, Karl-Heinz, Dr.

(57) **Zusammenfassung**

Gegenstand der Erfindung ist eine Halbleiterscheibe aus Silicium mit einer Ebenheit, ausgedrückt als GBIR von höchstens 0,2 µm und SFQRₘₐₓ von höchstens 0,13 µm.
Gegenstand der Erfindung ist auch ein Verfahren zur Herstellung hochebener Halbleiterscheiben mit schleierfrei polierter Vorderseite, das folgende Reihenfolge von Verfahrensschritten, die die Ebenheit der Halbleiterscheiben beeinflussen, gekennzeichnet ist:
a) Abtrennen der Halbleiterscheiben von einem Kristall;
b) Einebnen der Halbleiterscheiben durch ein Schleifverfahren;
c) Entfernen von geschädigten oberflächennahen Kristallbereichen durch Abtragsätzen, wobei ein Plasma-unterstütztes Ätzverfahren zur Anwendung kommt;
d) Plasma-unterstütztes Ätzen mit lokaler Auflösung; und
e) Schleierfreies Polieren der Halbleiterscheiben.

## Beschreibung

Die Erfindung betrifft eine hochebene Halbleiterscheibe aus Silicium und ein Verfahren zur Herstellung von hochebenen Halbleiterscheiben. Hochebene Halbleiterscheiben aus Silicium eignen sich für die Verwendung in der Halbleiterindustrie, insbesondere zur Fabrikation von elektronischen Bauelementen mit Linienbreiten gleich oder kleiner 0,13 µm.

Bei der Definition der Ebenheit von Siliciumscheiben wird gemäß des in der SEMI-Norm M1-94 von 1994, auf den Seiten 17-21 veröffentlichten Entscheidungsbaumes zwischen globaler Ebenheit (die gesamte Scheibenoberfläche abzüglich eines zu definierenden Randausschlusses betreffend) und lokaler Ebenheit (die Ebenheit einer begrenzten Fläche auf der Scheibe betreffend, die in der Regel der Fläche des darauf zu errichtenden Halbleiterbauelementes entspricht) unterschieden. Die globale Ebenheit wird meist durch den GBIR (global backsurface-referenced ideal plane / range = Bereich der positiven und negativen Abweichung von einer rückseitenbezogenen Idealebene für die gesamte Scheibenoberfläche) beschrieben, welcher der früher gebräuchlichen Angabe TTV (total thickness variation) entspricht. Die lokale Ebenheit wird oft als SFQR (site front-surface referenced least squares / range = Bereich der positiven und negativen Abweichung von einer über Fehlerquadratminimierung definierten Vorderseite für eine Bauelementefläche definierter Dimension) ausgedrückt; die Größe SFQRₘₐₓ gibt den höchsten SFQR-Wert für alle Bauelementeflächen auf einer bestimmten Scheibe an. Eine allgemein anerkannte Faustregel besagt, daß der SFQRₘₐₓ-Wert einer Scheibe gleich oder kleiner der auf dieser Scheibe möglichen Linienbreite von darauf herzustellbaren Halbleiterbauelementen sein muß (siehe beispielsweise 1997 National Technology Roadmap for Semiconductors [NTRS], Semiconductor Industry Association [SIA], San Jose, Table 20 auf S. 64). Die in der Vergangenheit häufiger verwendete Angabe LTV (local thickness variation; rückseitenbezogen; entspricht dem TTV einer Bauelementefläche) wird heute gemäß SEMI-Norm als SBIR bezeichnet.

Die Herstellung von relativ ebenen Siliciumscheiben für die Verwendung in der Halbleiterindustrie ist bekannt. Die konventionelle Prozeßsequenz zu ihrer Herstellung lautet: Sägen eines Kristalls zu Halbleiterscheiben und Läppen, Ätzen und Polieren der gesägten Halbleiterscheiben. Die am häufigsten verwendeten Sägeverfahren sind das Innenlochsägen oder das Drahtsägen. Nach dem Läppen folgt ein naßchemischer Ätzschritt zur weitgehenden Entfernung der oberflächennahen gestörten Kristallschichten. Da es sich bei Silicium um ein amphoteres Material handelt, kann in diesem Falle sowohl in alkalischem Medium, beispielsweise in konzentrierter Kalilauge, als auch in saurem Medium, beispielsweise in Gemischen aus konzentrierter Flußsäure mit konzentrierter Salpetersäure gegebenenfalls unter Zusatz weiterer Säuren wie Phosphor- oder Essigsäure, geätzt werden. Beiden Ausführungsformen gemeinsam ist, daß sie sicherheitstechnisch aufgrund der Aggressivität der eingesetzten konzentrierten Agenzien hohe Anforderungen an Medien- und Anlagentechnik sowie Bedien- und Wartungspersonal stellen. Daneben wirft eine sachgemäße Entsorgung der anfallenden Altlaugen und -säuren weitere Probleme auf, die nur unter Aufwendung hoher Kosten gelöst werden können.

Das Polieren wird in der Regel als zwei- oder dreistufiger Einseitenprozeß ausgeführt, wobei der jeweils letzte Schritt die endgültige schleierfreie Oberfläche erzeugt. Weitere vielfach in diese Prozeßsequenz eingefügte Schritte wie Kantenverrunden und Endreinigen sind für das Erscheinungsbild der so hergestellten Scheiben relevant, für deren Ebenheit jedoch nicht von unmittelbarer Bedeutung.

In der US-5,227,339 ist beschrieben, daß der Läpp- und der Ätzschritt in der konventionellen Prozeßsequenz durch einen Schleifschritt ersetzt werden können, wobei ein Orientierungsflat erst nach der Politur erzeugt wird. Am Beispiel von 150-mm-Scheiben wird gezeigt, daß die so hergestellten Scheiben nach Polieren TTV-Werte von 0,5-1,3 µm erreichen.

In der EP-628 992 A2 ist eine abgewandelte Prozeßsequenz beschrieben, bei der alkalisches Ätzen mit einer Rückseitenpolitur kombiniert ist. Geometriedaten sind in dieser Anmeldung nicht angegeben.

In der EP-755 751 A1 wird das in der weiter oben zitierten US-5,227,339 beschriebene Verfahren weiter verbessert, indem der Schleifschritt als Doppelseiten-Schleifschritt ausgeführt wird, bei welchem Scheibenvorder- und -rückseite gleichzeitig geschliffen werden, gefolgt von Einseiten- oder Doppelseitenpolitur. Geometriedaten für nach diesem Verfahren hergestellte Scheiben sind nicht angegeben.

In der EP-754 785 A1 ist eine verkürzte Linienführung umfassend Sägen - Kantenverrunden - Doppelseitenpolieren - Endpolieren - Reinigen vorgeschlagen, wobei zur Erreichung von TTV-Werten unter 1 µm mindestens 60 bis 80 µm Silicium im Doppelseitenpolierschritt abgetragen werden müssen. Bei der Bearbeitung von 150-mm-Scheiben werden LTVₘₐₓ-Werte von 0,25-0,4 µm erreicht.

In der EP-798 405 A2 wird die Prozeßsequenz Sägen - Kantenverrunden - Einebnen (Schleifen gefolgt von alkalischem Ätzen oder anstelle dieser beiden Schritte Plasmaätzen bevorzugt nach dem PACE-Verfahren = plasma-assisted chemical etching) - Doppelseitenpolieren beansprucht. Aus Fig. 7 in dieser Anmeldung ist ersichtlich, daß nach dem verfahren ein mittlerer TTV-Wert von 0,58 µm und ein mittlerer LTVₘₐₓ-Wert von 0,27 µm erzielt werden, wobei der Durchmesser der verwendeten Halbleiterscheiben nicht angegeben ist.

In der EP-798 766 A1 wird die konventionelle Prozeßsequenz dahingehend abgeändert, daß zwischen Abtragspolieren und Endpolieren ein Gasphasenätzschritt bevorzugt nach dem PACE-Verfahren, gegebenenfalls gefolgt von einer Wärmebehandlung der Scheibe, eingefügt wird. Anhand der Prozessierung von 200-mm-Scheiben wird gezeigt, daß die beschriebene Prozeßsequenz TTV-Resultate von 0,2-0,3 µm ermöglicht; lokale Geometriedaten sind nicht angegeben.

Alle in den zitierten Patenten und Patentanmeldungen beschriebenen Prozeßsequenzen, die den aktuellen Stand der Technik repräsentieren, weisen Nachteile auf. Alkalisches Ätzen, wie in den in EP-628 992 A2 und EP-798 405 A2 beschriebenen Prozeßfolgen beansprucht, führt zu einer Erhöhung der Konzentration von Metallen, z. B. Nickel, im Siliciumgitter (siehe hierzu z. B. T. Hosoya et al, J. Electrochem Soc. 132, Nr. 10, Seiten 2436-2439 [1985]). Naßchemisches Ätzen in jeglicher Form, wie auch in der EP-798 766 A1 vorgeschlagen, ist wegen der Entsorgungsproblematik der hochkonzentrierten Säuren und Laugen sowie sicherheitstechnisch wegen der Gefährlichkeit der eingesetzten Stoffe von Nachteil.

Moderne Halbleiterprozesse zur Herstellung von Schaltkreisen mit sehr kleinen Linienbreiten benötigen aus verschiedenen Gründen, beispielsweise dem Ausschluß von Partikeln, die zur Zerstörung der Bauelemente führen, polierte Scheibenrückseiten. Diese ist jedoch in Linien ohne Anwendung des Verfahrens der Doppelseitenpolitur, wie sie beispielsweise in der US-5,227,339 und der EP-798 766 A1 beschrieben sind, nicht oder nur unter kostenintensiver separater Rückseitenpolitur wie in EP-628 992 A2 beschrieben zu realisieren. Schleifen hat gegenüber der Läpptechnologie eine Reihe von vorteilen (sauberer Prozeß, da keine Schleifsole verwendet wird; kostengünstig; bessere Oberflächenqualität und Scheibengeometrie; Automatisierbarkeit) und wird daher in einigen der oben aufgeführten Anmeldungen eingesetzt. Jedoch werden durch den Schleifprozeß die oberen Kristallschichten je nach Körnung des Schleifzeugs bis in eine Tiefe von mindestens 1-10 µm geschädigt. Dieses Damage wird am kostengünstigsten durch einen naßchemischen Ätzschritt entfernt; wird auf letzteren verzichtet wie beispielsweise in EP-755 751 A1 vorgeschlagen, muß entsprechend mehr Material im deutlich kostspieligeren Polierschritt abgetragen werden.

Kostenmäßig nicht mehr tolerabel ist es, die Scheibe direkt nach dem Sägen zu polieren wie in der EP-754 785 A1 beschrieben, denn nach dem Sägen liegt das Damage erfahrungsgemäß bei 10-40 µm.

Allen der zitierten Patente bzw. Patentanmeldungen ist jedoch gemein, daß gemäß der beschriebenen Beispiele die mit den beanspruchten Sequenzen hergestellten Scheiben die Geometrieanforderungen für Halbleiterbauelemente mit Linienbreiten gleich oder kleiner 0,13 µm, d. h. SFQRₘₐₓ-Werte gleich oder kleiner oder gleich 0,13 µm, nicht erfüllen.

Es war daher die Aufgabe gestellt, hochebene Siliciumscheiben für die Verwendung in der Halbleiterindustrie zur Fabrikation von elektronischen Bauelementen mit Linienbreiten gleich oder kleiner 0,13 µm bereitzustellen, die in ihren weiteren Eigenschaften mindestens genau so gut wie die nach dem Stand der Technik hergestellten Scheiben sind und innerhalb des gleichen Herstellkostenrahmens gefertigt werden können.

Gegenstand der Erfindung ist eine hochebene Halbleiterscheibe aus Silicium, die gekennzeichnet ist durch eine Ebenheit ausgedrückt als GBIR von höchstens 0,2 µm und als SFQRₘₐₓ von höchstens 0,13 µm.

Gegenstand der Erfindung ist auch ein Verfahren zur Herstellung hochebener Halbleiterscheiben mit schleierfrei polierter Vorderseite durch Verknüpfung mehrerer Verfahrensschritte, das gekennzeichnet ist durch folgende Reihenfolge von Verfahrensschritten, die die Ebenheit der Halbleiterscheiben beeinflussen:
a) Abtrennen der Halbleiterscheiben von einem Kristall;
b) Einebnen der Halbleiterscheiben durch ein Schleifverfahren;
c) Entfernen von geschädigten oberflächennahen Kristallbereichen durch Abtragsätzen, wobei ein Plasma-unterstütztes Ätzverfahren zur Anwendung kommt;
d) Plasma-unterstütztes Ätzen mit lokaler Auflösung; und
e) Schleierfreies Polieren der Halbleiterscheiben.

Falls eine polierte Scheibenrückseite gewünscht wird, ist es sinnvoll, entweder einen Rückseiten-Polierschritt einzufügen oder zwischen dem Plasma-Abtragsätzschritt und dem Plasma-Lokalätzschritt einen kurzen Doppelseitenpolierschritt einzuführen.

Die erfindungsgemäße Prozeßsequenz kann prinzipiell zur Herstellung aller scheibenförmigen Testkörper eingesetzt werden, die aus einem Material bestehen, welches mit den eingesetzten mechanischen, chemischen und Plasmamethoden bearbeitet werden kann. Derartige Materialien, deren Weiterverarbeitung vorwiegend in der Halbleiterindustrie stattfindet, jedoch nicht auf diese beschränkt ist, sind zum Beispiel Silicium, Silicium/Germanium, Siliciumdioxid, Siliciumnitrid, Galliumarsenid und weitere sogenannte III-V-Halbleiter. Silicium in einkristalliner Form, beispielsweise kristallisiert durch einen Czochralski- oder einen Zonenziehprozeß, ist bevorzugt; Silicium mit einer Kristallorientierung (100), (110) oder (111) ist besonders bevorzugt. Das besagte Material kann dabei in geringen Mengen bestimmte Zuschlagstoffe zur Einstellung der gewünschten elektrischen und mechanischen Charakteristik enthalten; im Falle von Silicium können dies beispielsweise Bor, Indium, Phosphor, Arsen, Antimon oder Sauerstoff in Mengen zwischen 10¹⁰ und 10²⁰ Atomen pro cm³ sein, wobei die Erfindung von der exakten Zusammensetzung des Materials nicht berührt wird. Die bevorzugt hergestellten Siliciumscheiben können prinzipiell jeden Durchmesser besitzen, wobei aufgrund des Anforderungsprofils in der weiterverarbeitenden Industrie, vor allem in der Halbleiterbauelemente-Fertigung (wirtschaftliche Fertigung von hochintegrierten Schaltkreisen mit sehr geringen Linienbreiten, vorzugsweise gleich oder kleiner 0,13 µm), Scheibendurchmesser gleich oder größer 200 mm besonders bevorzugt sind, beispielsweise Scheibendurchmesser von 200 mm, 300 mm, 400 mm, 450 mm und 675 mm. Die Dicke der erfindungsgemäß hergestellten Scheiben kann in einer großen Bandbreite variieren, die von sehr dünnen Scheiben (wenige 100 µm) beispielsweise für Chipkartenanwendungen bis hin zu sehr dicken Scheiben (einige cm) beispielsweise als Substrate für energetische und lithographische Tests reichen kann. Besonders bevorzugt sind Scheibendicken zwischen 500 µm und 1200 µm. Derartige Scheiben können entweder direkt als Ausgangsmaterial für die Herstellung von Halbleiterbauelementen eingesetzt werden oder nach Aufbringen von Schichten wie Rückseitenversiegelungen oder einer epitaktischen Beschichtung der Scheibenvorderseite mit Silicium oder geeigneten weiteren Halbleitermaterialien oder aber nach Konditionierung durch eine Wärmebehandlung beispielsweise unter Wasserstoff- oder Argonatmosphäre ihrem Bestimmungszweck zugeführt werden. Neben der Herstellung von Scheiben aus einem homogenen Material kann die Erfindung natürlich auch zur Herstellung von mehrschichtig aufgebauten Halbleitersubstraten wie SOI-Scheiben (silicon-on-insulator) und sogenannten bonded wafers eingesetzt werden.

Im folgenden wird die erfindungsgemäße Prozeßsequenz zur Herstellung hochebener Scheiben anhand der besonders bevorzugten einkristallinen Siliciumscheiben mit einem Durchmesser gleich oder größer 200 mm näher erläutert.

Zunächst wird der zu verarbeitende Silicium-Einkristall abgelängt, das heißt mittels einer geeigneten Sägevorrichtung von seinem Anfangs- und Endkonus befreit, und auf einen Durchmesser rundgeschliffen, welcher geringfügig, zum Beispiel um 1 mm, größer ist als der Durchmesser der prozessierten Scheibe, um eine verrundung der scharf begrenzten, mechanisch sehr empfindlichen Scheibenkante zuzulassen. Falls dies gewünscht wird, kann der Kristall mit einem Orientierungsmerkmal zur Indentifizierung der Kristallachsen versehen werden, beispielweise einein Notch oder einem Flat. Das Zersägen des Einkristalls in Scheiben kann nach dem Stand der Technik nach verschiedenen Verfahren erfolgen, zum Beispiel durch Innenlochsägen, gegebenenfalls kombiniert mit dem sogenannten grind-slice-Verfahren, oder durch Band- oder Drahtsägen. Wegen der dem Fachmann insbesondere für größere Scheibendurchmesser bekannten Vorteile hinsichtlich Scheibengeometrie und Durchsatz ist das Drahtsägen eine bevorzugte Ausführungsform und kann beispielsweise mit einer Säge, die in der EP-733 429 A1 beschrieben ist, betrieben werden.

Mittels einer geeignet profilierten Schleifscheibe werden die Kanten der gesägten Scheiben sinnvollerweise an dieser Stelle des Prozeßflusses zu dem gewünschten Kantenprofil verrundet. Dieser Schritt ist für die spätere Ebenheit der erfindungsgemäß hergestellten Scheiben im Prinzip ohne Bedeutung, ist aber zum Schutz der Scheibenkanten vor Beschädigungen (beispielsweise Ausbrüchen hervorgerufen durch Bearbeitung und Transport) relevant.

Die erhaltenen gesägten, kantenverrundeten Scheiben, die je nach Durchmesser und Art des Sägeprozesses GBIR-Werte im Bereich von 10-30 µm und Kristallgitterstörungen bis in eine Tiefe im Bereich von 10-40 µm aufweisen, werden nun zwecks Verbesserung der Geometrie und teilweisem Abtrag der zerstörten Kristallschichten einem Schleifschritt unterzogen. Prinzipiell sind die unterschiedlichsten Ausführungsweisen von Schleifprozessen denkbar, die in der Literatur eingehend beschrieben sind. Eine bevorzugte Ausführungsform für das erfindungsgemäße Verfahren ist die Methode des Rotationsschleifens, wie sie beispielsweise in der EP-272 531 A1 beschrieben ist. Hierbei wird sinnvollerweise zunächst eine Seite der Scheibe geschliffen, die Scheibe gewendet und anschließend die andere Seite geschliffen. Bevorzugt zur Anwendung kommen dabei Diamant-haltige Schleifscheiben, besonders bevorzugt Schleifscheiben mit Kunstharzgebundenen Diamanten. Die eingebetteten Diamantsplitter besitzen dabei eine Körnung bevorzugt von 400 bis 3000 Mesh, besonders bevorzugt von 600 bis 2000 Mesh. Es ist jedoch auch möglich, nur eine Scheibenseite zu schleifen, wobei diese Ausführungsform weniger bevorzugt ist. In einer weiteren, ebenfalls bevorzugten Ausführungsform werden beide Scheibenseiten nacheinander zunächst mit einer Schleifscheibe der Körnung 400 bis 1000 Mesh und anschließend beide Scheibenseiten nacheinander mit einer Schleifscheibe der Körnung 1500 bis 2500 Mesh geschliffen. Eine weitere bevorzugte Ausführungsform des Schleifschrittes im Rahmen des erfindungsgemäßen Verfahrens ist das Doppelseitenschleifen, wie es beispielsweise in der bereits zitierten EP-755 751 A1 beschrieben ist. Anstelle des sequentiellen Schleifens der beiden Scheibenseiten werden in diesem Falle beide Scheibenseiten gleichzeitig geschliffen. Anstelle der Schleifscheiben können hierbei Schleifkörper, sogenannte Pellets, mit gleicher Zusammensetzung eingesetzt werden. Der Siliciumabtrag pro Scheibenseite beträgt beim Schleifschritt bevorzugt 10-100 µm, besonders bevorzugt 20-60 µm. Die geschliffenen Scheiben weisen je nach Ausführungsform des Schleifschrittes GBIR-Werte im Bereich von 0,5-2 µm und eine Störung der äußeren Kristallschichten bis in eine Tiefe von 1-10 µm auf.

Erfindungsgemäß werden geschädigte oberflächennahe Kristallbereiche nach dem Schleifen durch Trockenätzen mit Unterstützung eines Plasmas entfernt. Damit werden auch alle Probleme vermieden, die mit einer naßchemischen Abtragsätze verknüpft sind. Beim Trockenätzen werden in einem Plasma, welches eine Temperatur zwischen 5.000-10.000 °C besitzt, beispielsweise einem Argonplasma, reaktive Teilchen, beispielsweise Radikale oder Ionen, erzeugt, die mit der Oberfläche des zu ätzenden Substrates reagieren und diese abtragen. Für die erfindungsgemäße Verknüpfung von Prozeßschritten ist ein Verfahren bevorzugt, bei welchem der Ätzabtrag durch im Plasma erzeugte Neutralteilchen, etwa Halogenradikale wie Fluor*, Chlor* oder Brom*, erfolgt; besonders bevorzugt ist dabei ein Verfahren, bei welchem der Ätzabtrag durch im Plasma erzeugte Fluorradikale erfolgt, was zu sehr geringer Oberflächenschädigung und zu sehr gutem Geometrieerhalt der Scheibe führt. Fluorradikale werden dabei aus fluorhaltigen Verbindungen wie beispielsweise CF₄, NF₃, SF₆ oder CNF erzeugt; auch Gemische aus verschiedenen fluorhaltigen Verbindungen können problemlos eingesetzt werden. Eine bevorzugte Ausführungsweise des Plasma-Abtragsätzschrittes ist in der DE-4132564 A1 und der DE-4132565 A1 beschrieben. Bei diesem im Vakuum durchgeführten verfahren werden in einem Plasma fluorhaltige Verbindungen in Gegenwart eines sauerstoffhaltigen Gases, beispielsweise N₂O, NO, NO₂ oder Sauerstoff/Stickstoff-Gemische, unter Unterstützung durch einen Mikrowellengenerator erzeugt. Eine weitere bevorzugte Ausführungsform ist das Ätzen mit einem sogenannten Plasmajet, wie es beispielsweise aus WO 93/16573, WO97/45856, US-5,310,456 oder US-5,474,642 hervorgeht. Ein derartiges Verfahren arbeitet unter Atmosphärendruck beispielsweise an der Luft, wobei die aktiven Radikale durch thermische Zersetzung der Ausgangsverbindungen erzeugt werden. Bei beiden bevorzugten Verfahren werden in der Regel die beiden Scheibenoberflächen nacheinander geätzt, wobei die Verfahrensausführung derart ist, daß gleichzeitig von der Scheibenkante ebenfalls die oberflächennahen zerstörten Kristallschichten entfernt werden. Bei geeignetem apparativem Aufbau können die Verfahren jedoch auch in einer Weise ausgeführt werden, die einen gleichzeitigen Materialabtrag von Vorder- und Rückseite ermöglicht. Der Plasma-Abtragsätzschritt im Rahmen des erfindungsgemäßen Verfahrens wird bevorzugt mit einer Abtragsrate zwischen 3 und 30 mm³/s durchgeführt, wobei Abtragsraten zwischen 5 und 15 mm³/s besonders bevorzugt sind. Nach Anwendung des Plasma-Abtragsätzverfahrens auf beide Scheibenseiten - bevorzugt abgetragen werden 5-50 µm pro Seite, besonders bevorzugt 8-20 µm pro Seite - weisen die Scheiben GBIR-Werte im Bereich von 0,5-1,5 µm und eine Störung der oberflächennahen Kristallschichten bis in eine Tiefe von 0,1-0,8 µm auf. Um einen gleichmäßigen Siliciumabtrag im Plasma-Abtragsätzschritt zu gewährleisten, kann es sinnvoll sein, die Scheiben unmittelbar vor diesem Schritt gezielt zu hydrophilieren. Dies kann beispielsweise durch Behandlung in einem alkalischen Bad in Gegenwart eines oxidierenden Agens', etwa einer wäßrigen Lösung von Ammoniak und Wasserstoffperoxid, oder durch Ozonbehandlung der Scheiben gegebenenfalls nach Entfernung von bereits vorhandenem Oberflächenoxid in einer wäßrigen Flußsäurelösung erfolgen.

In der erfindungsgemäßen Prozeßsequenz schließt sich nun ein Geometrie-Korrekturschritt durch lokalen Siliciumabtrag ebenfalls mit Unterstützung eines Plasmas an. Dazu werden die Siliciumscheiben nach Durchlauf der bereits beschriebenen Bearbeitungsschritte hinsichtlich ihrer Geometrie charakterisiert, was beispielsweise mit einem nach einem optischen oder kapazitiven Meßprinzip arbeitenden Meßinstrument geschehen kann; die Verwendung eines optischen Meßinstrumentes beispielsweise nach dem Prinzip der Lasertriangulation sowie der Durchlicht-, Schräglicht- oder Differentialinterferometrie ist bevorzugt, da in diesem Fall exaktere Meßergebnisse und damit eine effektivere Geometriekorrektur zu erwarten sind. Aufgrund der Meßdatenbasis wird die von einem bestimmten Flächeninkrement der Scheibe abzutragende Siliciummenge errechnet. Prinzipiell gelten für die Chemie des Plasma-Lokalätzschrittes dieselben Rahmenbedingungen wie für den Plasma-Abtragsschritt weiter oben aufgeführt: bevorzugt sind wiederum in einem Plasma, beispielsweise einem Argonplasma generierte Halogenradikale, wobei Fluorradikale, die aus fluorhaltigen Verbindungen wie beispielsweise CF₄, NF₃, SF₆ oder CNF oder Gemischen aus derartigen fluorhaltigen Verbindungen erzeugt werden können, besonders bevorzugt sind. Der wesentliche Unterschied zum Plasma-Abtragsätzen besteht darin, daß zur Erzielung einer exakten lokalen Geometriekorrektur unter Aufwendung von deutlich geringeren Energiemengen gearbeitet wird, die zu Abtragsraten zwischen bevorzugt 0,1 und 1,0 mm³/s, besonders bevorzugt 0,2 und 0,6 mm³/s führen. Eine besonders bevorzugte Ausführungsvariante des Plasma-Lokalätzens ist das sogenannte PACE-Verfahren (plasma-assisted chemical etching), wie es beispielsweise in US-4,668,366, US-5,254,830, US-5,290,382 und US-5,336,355 sowie den Veröffentlichungen Applications of plasma-assisted chemical etching to advanced wafer processing (P. B. Mumola, Technical Proceedings Semicon Japan 1993) und Advances in the production of thin-film bonded SOI and ultra flat bulk wafers using plasma assisted chemical etching (P. B. Mumola and G. J. Gardopee, Proceedings of the International Conference on Solid State Devices and Materials 1994, Yokohama, Japan, S. 256-258) beschrieben ist. Beim PACE-Verfahren wird durch Anwendung von Radiofrequenz ein Plasma erzeugt, in welchem die beschriebenen Ausgangssubstanzen durch Elektronenanregung teilweise in reaktive Radikale überführt werden, wobei der Siliciumabtrag von der Scheibenoberfläche im Vakuum, bevorzugt jedoch nicht im Hochvakuum, sondern bei Drucken von wenigen Torr des verwendeten Ätzgases stattfindet. Der PACE-Prozeß kann natürlich prinzipiell auf beide Scheibenseiten angewendet werden, wobei dies gegenüber der einseitigen Anwendung keine weiteren Vorteile hinsichtlich der Geometrie bringt; eine einseitige Anwendung entweder auf der Scheibenvorder- oder der Scheibenrückseite ist daher bevorzugt. Der Materialabtrag liegt dabei bevorzugt zwischen 0,5 und 5 µm, besonders bevorzugt zwischen 0,5 und 3 µm. Da die Silicium-Ätzrate beim PACE-Prozeß deutlich höher als die SiO₂-Ätzrate ist, kann es zur Erhöhung des Durchsatzes und zur Verringerung von Prozeßvariationen sinnvoll sein, die einzuebnenden Scheiben vor dem PACE-Prozeß zum Beispiel durch Eintauchen in eine verdünnte wäßrige Flußsäurelösung von einer eventuell vorhandenen Oberflächenoxidschicht zu befreien. Die Scheiben können jedoch auch nach denselben Methoden wie beim Plasma-Abtragsätzen beschrieben vor dem Plasma-Lokalätzschritt gezielt hydrophiliert werden, was in gewissen Fällen ebenfalls von Vorteil sein kann. Der PACE-Prozeß hinterläßt im Rahmen des Gegenstandes dieser Erfindung nahezu keine Störung der äußeren Kristallschichten, und es werden GBIR-Werte unterhalb von 0,2 µm gemessen.

Anschließend wird die Scheibenvorderseite schleierfrei poliert, was nach dem Stand der Technik mit einem weichen Poliertuch unter Zuhilfenahme einer alkalischen Poliersole stattfinden kann; zum Erhalt der bis zu diesem Schritt erzeugten guten Scheibengeometrie liegt der Siliciumabtrag von der Scheibe dabei relativ niedrig, bevorzugt zwischen 0,05 und 1,5 µm, besonders bevorzugt zwischen 0,1 und 0,7 µm. In der Literatur wird dieser Schritt oft als CMP-Politur (chemo-mechanical polishing) bezeichnet. Eine bevorzugte Ausführungsform des Schleierfreipolierschrittes ist die Verwendung eines Poliertuches auf Polyurethanbasis mit einer Poliersole mit einem pH-Wert von 9-10 aus 1-5 Gew.-% SiO₂ in Wasser, wobei der Polierdruck zwischen 0,1 und 0,3 bar liegt. Der erfindungsgemäßen Prozeßkette folgt in der Regel eine Reinigung nach dem Stand der Technik, die entweder als Batchprozeß unter gleichzeitiger Reinigung einer Vielzahl von Scheiben in Bädern oder mit einem Sprühverfahren oder als Einzelscheibenprozeß ausgeführt werden kann. Im Rahmen der Erfindung bevorzugt ist eine Badreinigung nach dem sogenannten RCA-Verfahren unter Verwendung einer Sequenz von alkalischen, sauren und Reinstwasserbädern, wie sie beispielsweise in Cleaning solutions based an hydrogen peroxide for use in Silicon semiconductor technology (W. Kern und D. A. Puotinen, RCA Review 1970, S. 187-206), The evolution of Silicon wafer cleaning technology (W. Kern, J. Electrochem. Soc. 137, Nr. 6, S. 1887-1892 [1990]) und Wafer cleaning: Making the transition to surface engineering (P. Singer, Semiconductor International, Oct. 1995, S. 88-92) beschrieben ist.

Falls gewünscht wird, daß die nach dem erfindungsgemäßen Verfahren hergestellten Scheiben eine polierte Rückseite besitzen sollen, wie dies zwecks Vermeidung von Querkontamination mit an der Rückseite anhaftenden Partikel bei modernen Verfahren zur Herstellung von Halbleiterbauelementen vielfach der Fall ist, kann prinzipiell auf zwei verschiedene Vorgehensweisen zurückgegriffen werden, welche die Erfindung selbst in keiner Weise einschränken. Zum einen kann ein Rückseitenpolierschritt analog dem weiter oben beschriebenen Endpolierschritt durchgeführt werden; dieser Rückseitenpolierschritt wird sinnvollerweise vor dem Endpolierschritt der Scheibenvorderseite durchgeführt, zum Beispiel zwischen dem Plasma-Lokalätzschritt und dem Endpolierschritt der Vorderseite. Es kann jedoch auch ein Doppelseitenpolierschritt in die Prozeßkette eingefügt werden, sinnvollerweise zwischen dem Plasma-Abtragsätzschritt und dem Plasma-Lokalätzschritt, in welchem deutlich weniger Material abgetragen wird als beispielsweise nach der in der bereits zitierten EP-754 785 A1 offenbarten Verfahren, nämlich bevorzugt 5 bis 50 µm pro Scheibenseite, besonders bevorzugt 10 bis 20 µm pro Scheibenseite. Ein geeignetes Verfahren zur Doppelseitenpolitur ist beispielsweise in der EP-776 030 A2 veröffentlicht. Eine bevorzugte Ausführungsform des Doppelpolierschrittes ist die Verwendung eines Poliertuches auf Polyurethanbasis mit eingearbeiteten Polyethylenfasern mit einer bevorzugten Härte von 40 bis 120 (Shore A) und einer besonders bevorzugten Härte von 60 bis 90 (Shore A) in Gegenwart einer Poliersole mit einem pH-Wert von bevorzugt 9-12, besonders bevorzugt 10-11, aus bevorzugt 1-10 Gew.-%, besonders bevorzugt 1-5 Gew.-% SiO₂ in Wasser, wobei der Polierdruck bevorzugt zwischen 0,1 und 0,5 bar, besonders bevorzugt zwischen 0,15 und 0,3 bar liegt.

Falls notwendig, kann an einer beliebigen Stelle der erfindungsgemäßen Prozeßkette ein Wärmebehandlungsschritt der Scheiben eingeführt werden, beispielsweise um thermische Donatoren zu vernichten oder um eine Störung von oberflächennahen Kristallschichten auszuheilen. Dabei kann es beispielsweise zur Vermeidung einer Gitterkontamination durch Metallatome sinnvoll sein, die Scheiben vor dem Wärmebehandlungsschritt einer naßchemischen Reinigung nach dem Stand der Technik zu unterziehen. Bevorzugt wird die Wärmebehandlung nach dem Plasma-Abtragsätzschritt oder nach dem Plasma-Lokalätzschritt in einem Temperaturbereich zwischen 400 °C und 800 °C durchgeführt. Ebenfalls gewünscht sein könnten eine Laserbeschriftung zur Scheibenidentifizierung oder ein Kantenpolierschritt, die sich an geeigneter Stelle, zum Beispiel vor oder nach dem Schleifen im Falle der Lasermarkierung sowie vor oder nach dem Plasma-Lokalätzschritt im Falle des Kantenpolierens einfügen lassen. Eine Reihe weiterer, für bestimmte Produkte erforderliche Prozeßschritte wie beispielsweise die Aufbringung von Rückseitenbeschichtungen aus Polysilicium, Siliciumoxid oder Siliciumnitrid oder die Aufbringung einer Epitaxieschicht aus Silicium oder weiteren halbleitenden Materialien auf die Vorderseite der Siliciumscheibe läßt sich ebenfalls nach dem Fachmann bekannten Verfahren an den geeigneten Stellen in den Prozeßfluß einbauen. Je nach Art der Prozeßverknüpfung kann es notwendig oder hilfreich sein, die Scheiben vor oder nach einzelnen Prozeßschritten einer Batch- oder Einzelscheibenreinigung nach dem Stand der Technik zu unterziehen. Der Gegenstand der Erfindung, die Bereitstellung hochebener Halbleiterscheiben aus Silicium, wird dadurch nicht berührt.

Erstaunlich und nicht zu erwarten ist, daß sich mit der erfindungsgemäßen Prozeßverknüpfung Sägen - Schleifen - Plasmaabtragsätzen - Plasmalokalätzen - Schleierfreipolieren hochebene Siliciumscheiben mit GBIR-Werten gleich oder kleiner 0,2 µm und SFQRₘₐₓ-Werten gleich oder kleiner 0,13 µm herstellen lassen. Sobald einer dieser drei Schritte durch einen in der konventionellen Scheibenherstellung üblichen Schritt ersetzt wird, beispielsweise Schleifen durch Läppen oder Plasma-Abtragsätzen durch naßchemisches Ätzen, oder entfällt, beispielsweise Plasma-Lokalätzen, werden Scheiben mit signifikant schlechteren globalen und lokalen Geometrien erhalten, welche im Gegensatz zu den erfindungsgemäß hergestellten Scheiben die strengen Geometrieanforderungen an Scheiben als Ausgangsmaterial für Halbleiterbauelemente mit Linienbreiten gleich oder kleiner 0,13 µm nicht erfüllen. Das erfindungsgemäße Verfahren verzichtet auf die Verwendung des problematischen naßchemischen Ätzschrittes. Hinsichtlich der weiteren üblicherweise zur Scheibencharakterisierung herangezogenen, dem Fachmann wohlbekannten Parameter wie Anzahl an Lichtstreuzentren, Rauhigkeit, Haze, Metallkontaminationen, Lebensdauer, Magic-Mirror-Defekte usw. weisen die erfindungsgemäß hergestellten Scheiben keine Nachteile gegenüber den nach dem Stand der Technik hergestellten Scheiben auf. Erstaunlich und ebenfalls nicht zu erwarten ist, daß die Kosten pro nach dem erfindungsgemäßen verfahren produzierter Scheibe die Kosten pro nach dem Stand der Technik hergestellter Scheibe entsprechender Größe und Ausführungsform nicht übersteigen und in der Regel sogar unterschreiten, womit ein wirtschaftlich konkurrenzfähiges, jedoch leistungsfähigeres Verfahren für die Herstellung von Scheiben als Ausgangsmaterial für die Fertigung von Halbleiterbauelementen zur Verfügung steht.

Alle im folgenden aufgeführten Vergleichsbeispiele und Beispiele betreffen die Herstellung von Siliciumscheiben mit einem Durchmesset von (300±0,2) mm, einer Dicke von (775±25) µm, einer schleierfrei polierten Vorderseite und einer polierten Rückseite, einem Sauerstoffgehalt von (6±1)·10¹⁷ Atomen/cm³ und einer Bor-Dotierung, die zu einem widerstand im Bereich von 10-20 Ωcm führt. Die dazu benötigten Kristalle werden nach dem Stand der Technik gezogen, abgelängt, rundgeschliffen, auf einer handelsüblichen Drahtsäge in Scheiben zersägt und kantenverrundet. Die Beispiele sind exemplarisch für die Erfindung, schränken deren Umfang jedoch in keiner Weise ein.

### Vergleichsbeispiel 1

Es wird wie in einer gemäß EP-798 405 A2 bevorzugten Ausführungsform vorgegangen mit der Ausnahme, daß aufgrund des weiter oben diskutierten Kontaminationsrisikos sauer anstatt alkalisch geätzt wird: Die kantenverrundeten Scheiben werden auf einer Rotationsschleifmaschine mit einer Schleifscheibe aus Kunstharz-gebundenen Diamanten der Körnung 600 Mesh geschliffen, wobei nacheinander von der Scheibenvorder- und -rückseite je 30 µm Silicium abgetragen werden. Es folgt der Sauerätzschritt nach dem Strömungsätzverfahren in einer Mischung aus 90 Gew.-% konzentrierter Salpetersäure (70 Gew.-% in wäßriger Lösung) und 10 Gew.-% konzentrierter Flußsäure (50 Gew.-% in wäßriger Lösung), wobei pro Scheibenseite gleichzeitig je 10 µm Silicium abgetragen werden. Ein Doppelseitenpolierschritt wird mit einem Polyurethan-Poliertuch der Härte 70 (Shore A) unter Verwendung einer Poliersole mit einem SiO₂-Feststoffgehalt von 4 Gew.-% und einem pH-Wert von 11 unter einem Anpreßdruck von 0,3 bar durchgeführt, wobei gleichzeitig je 25 µm Silicium pro Scheibenseite abgetragen werden. Abschließend wird eine Endpolitur der Scheibenvorderseite zur Gewährleistung einer schleierfreien Oberfläche mit einem weichen Polyurethan-Poliertuch und einer Poliersole mit einem SiO₂-Feststoffgehalt von 2 Gew.-% und einem pH-Wert von 10 mit einem Anpreßdruck von 0,2 bar unter Abtrag von 0,5 µm sowie eine Endreinigung nach dem RCA-Verfahren durchgeführt.

### Vergleichsbeispiel 2

Es wird vorgegangen wie in Vergleichsbeispiel 1 beschrieben mit zwei Ausnahmen: Zum einem werden im Doppelseitenpolierschritt nur 20 µm pro Seite abgetragen; zum anderen wird zwischen Doppelseiten- und Endpolitur auf der Vorderseite ein Plasma-Ätzschritt mit lokaler Geometriekorrektur nach dem PACE-Verfahren unter Vakuum mit SF₆/Argon und Elektronenanregung durchgeführt, wobei 2 µm abgetragen werden. Diese Ausführung entspricht der in der EP-798 766 A1 beanspruchten Vorgehensweise, wobei aufgrund der oben diskutierten Nachteile das Läppen durch Schleifen ersetzt ist.

### Vergleichsbeispiel 3

Es wird vorgegangen wie in Vergleichsbeispiel 1 beschrieben mit zwei Ausnahmen: Zum einem wird anstelle des Sauerätzens ein Ätzschritt nach dem Plasmajet-Verfahren unter Atmosphärendruck mit CF₄/Argon und thermischer Anregung durchgeführt, wobei nacheinander je 10 µm von Vorder- und Rückseite abgetragen werden; zum anderen werden im Doppelseitenpolierschritt wie im Vergleichsbeispiel 2 nur 20 µm pro Seite abgetragen.

### Beispiel 1

Die kantenverrundeten Scheiben werden auf einer Rotationsschleifmaschine zunächst mit einer Schleifscheibe aus Kunstharz-gebundenen Diamanten der Körnung 600 Mesh geschliffen, wobei nacheinander von der Scheibenvorder- und -rückseite je 20 µm Silicium abgetragen werden. Anschließend werden Vorder- und Rückseite auf der selben Maschine erneut mit wiederum 20 µm Abtrag pro Seite überschliffen, wobei diesmal eine analog aufgebaute Schleifscheibe mit einer feineren Körnung von 2000 Mesh zum Einsatz kommt. Es folgt ein Ätzschritt nach dem Plasmajet-Verfahren unter Atmosphärendruck mit CF₄/Argon und thermischer Anregung, wobei nacheinander je 10 µm von Vorder- und Rückseite abgetragen werden. Es schließt sich unmittelbar ein Plasma-Ätzschritt mit lokaler Geometriekorrektur nach dem PACE-Verfahren unter Vakuum mit SF₆/Argon und Elektronenanregung an, wobei 2 µm abgetragen werden. Es folgt nacheinander eine Politur der Scheibenrückseite und eine Endpolitur der Scheibenvorderseite zur Gewährleistung einer schleierfreien Oberfläche jeweils mit einem weichen Polyurethan-Poliertuch und einer Poliersole mit einem SiO₂-Feststoffgehalt von 2 Gew.-% und einem pH-Wert von 10 mit einem Anpreßdruck von 0,2 bar unter Abtrag von 0,5 µm sowie eine Endreinigung nach dem RCA-Verfahren.

### Beispiel 2

Es wird vorgegangen wie in Beispiel 1 beschrieben mit zwei Ausnahmen: Zum einen werden Vorder- und Rückseite gleichzeitig mit Schleifkörpern der Körnung 600 Mesh nach dem Doppelseitenschleifverfahren unter Abtrag von 35 µm pro Seite geschliffen; zum anderen werden beim Plasmajet-Abtragsätzen 15 µm pro Seite abgetragen.

### Beispiel 3

Es wird vorgegangen wie in Beispiel 1 beschrieben mit drei Ausnahmen: Zum einen bleibt der Schleifschritt auf die Verwendung von Schleifscheiben der Körnung 600 Mesh beschränkt, und es werden 30 µm pro Seite abgetragen; zum anderen wird zwischen Plasmajet-Abtragsätzen und PACE-Lokalätzen ein Doppelseitenpolierschritt mit einem Polyurethan-Poliertuch der Härte 70 (Shore A) unter Verwendung einer Poliersole mit einem SiO₂-Feststoffgehalt von 4 Gew.-% und einem pH-Wert von 11 unter einem Anpreßdruck von 0,3 bar durchgeführt, wobei 15 µm pro Seite abgetragen werden; zum dritten entfällt der Rückseitenpolierschritt, da durch das Doppelseitenpolieren bereits die gewünschte polierte Rückseite erzeugt wurde.

### Beispiel 4

Es wird vorgegangen wie in Beispiel 3 beschrieben mit der Ausnahme, daß der Schleifschritt mit gleicher Körnung und gleichem Abtrag als Doppelseitenschleifschritt ausgeführt wird.

Die nachfolgende Tabelle faßt die Gesamtabträge (Zielwerte) in den beschriebenen Vergleichsbeispielen und Beispielen zusammen (RS = Rückseite; VS = Vorderseite; DS = Doppelseiten; SÄ = Sauerätze; ^{*)} 600 + 2000 Mesh):

| Beispiel | Schleifen 600 Mesh | Plasmajet | DSP | PACE | Polieren (RS) | Endpolieren (VS) |
|---|---|---|---|---|---|---|
| Vergleich 1 | 60 µm | 20 µm (SÄ) | 50 µm | --- | --- | 0,5 µm |
| Vergleich 2 | 60 µm | 20 µm (SÄ) | 40 µm | 2 µm | --- | 0,5 µm |
| Vergleich 3 | 60 µm | 20 µm | 40 µm | --- | --- | 0,5 µm |
| Beispiel 1 | 80 µm ^{*)} | 20 µm | --- | 2 µm | 0,5 µm | 0,5 µm |
| Beispiel 2 | 70 µm (DS) | 30 µm | --- | 2 µm | 0,5 µm | 0,5 µm |
| Beispiel 3 | 60 µm | 20 µm | 30 µm | 2 µm | --- | 0,5 µm |
| Beispiel 4 | 60 µm (DS) | 20 µm | 30 µm | 2 µm | --- | 0,5 µm |

### Geometriewerte der hergestellten Scheiben

Je 15 nach den oben aufgeführten Vergleichsbeispielen und Beispielen hergestellte 300-mm-Siliciumscheiben werden mit einem optischen Meßinstrument hinsichtlich ihrer Geometrie charakterisiert, wobei 3 mm Randausschluß und eine Halbleiterbauelementgröße von 25 mm × 25 mm zugrunde gelegt wurden. Die nachfolgende Tabelle gibt den arithmetischen Durchschnitt und die Standardabweichung Sigma für den globalen Ebenheitswert GBIR und den lokalen Ebenheitswert SFQRₘₐₓ an:

| Beispiel | GBIR (µm) | SFQRₘₐₓ (µm) |
|---|---|---|
| Vergleich 1 | 0,50 ± 0,12 | 0,20 ± 0,05 |
| Vergleich 2 | 0,32 ± 0,06 | 0,15 ± 0,03 |
| Vergleich 3 | 0,44 ± 0,09 | 0,21 ± 0,05 |
| Beispiel 1 | 0,18 ± 0,04 | 0,10 ± 0,03 |
| Beispiel 2 | 0,19 ± 0,05 | 0,11 ± 0,02 |
| Beispiel 3 | 0,17 ± 0,03 | 0,08 ± 0,02 |
| Beispiel 4 | 0,14 ± 0,03 | 0,07 ± 0,01 |

### Weitere Charakterisierung der hergestellten Scheiben

Die Vorderseiten der nach den oben aufgeführten Vergleichsbeispielen und Beispielen hergestellten 300-mm-Siliciumscheiben werden mit den üblichen Methoden hinsichtlich Lichtstreuzentren (LLS, localized light scatterers), Rauhigkeit, Haze und Metallkontaminationen sowie die Scheiben in ihrer Gesamtheit hinsichtlich Magic-Mirror-Defekten, Minoritätsträger-Lebenszeiten und Metallkontaminationen charakterisiert. Es werden keine statistisch relevanten Abweichungen zwischen den einzelnen Gruppen beobachtet.

## Patentansprüche

**1.** Halbleiterscheibe aus Silicium, gekennzeichnet durch eine Ebenheit, ausgedrückt als GBIR von höchstens 0,2 µm und SFQRₘₐₓ von höchstens 0,13 µm.

**2.** Verfahren zur Herstellung hochebener Halbleiterscheiben mit schleierfrei polierter Vorderseite durch Verknüpfung mehrerer Verfahrensschritte, gekennzeichnet durch folgende Reihenfolge von Verfahrensschritten, die die Ebenheit der Halbleiterscheiben beeinflussen:
a) Abtrennen der Halbleiterscheiben von einem Kristall;
b) Einebnen der Halbleiterscheiben durch ein Schleifverfahren;
c) Entfernen von geschädigten oberflächennahen Kristallbereichen durch Abtragsätzen, wobei ein Plasma-unterstütztes Ätzverfahren zur Anwendung kommt;
d) Plasma-unterstütztes Ätzen mit lokaler Auflösung; und
e) Schleierfreies Polieren der Halbleiterscheiben.

**3.** Verfahren nach Anspruch 2, dadurch gekennzeichnet, daß ein Schleifverfahren zur Anwendung kommt, bei dem Vorder- und Rückseiten der Halbleiterscheiben nacheinander geschliffen werden.

**4.** Verfahren nach Anspruch 2, dadurch gekennzeichnet, daß ein Schleifverfahren zur Anwendung kommt; bei dem Vorder- und Rückseiten der Halbleiterscheiben gleichzeitig geschliffen werden.

**5.** Verfahren nach einem der Ansprüche 2 bis 4, dadurch gekennzeichnet, daß mit Schleifscheiben oder Schleifkörper aus kunstharzgebundenen Diamanten mit einer Körnung von 400 mesh bis 3000 mesh geschliffen wird.

**5**. Verfahren nach einem der Ansprüche 2 bis 5, dadurch gekennzeichnet, daß beim Abtragsätzen mit einer Abtragsrate von 3 bis 30 mm³/s geätzt wird.

**7.** Verfahren nach einem der Ansprüche 2 bis 6, dadurch gekennzeichnet, daß beim Plasma-unterstützten Ätzen mit lokaler Auflösung mit einer Abtragsrate von 0,1 bis 1,0 mm³/s geätzt wird und dabei überwiegend ein Angriff von Neutralteilchen auf die Halbleiterscheiben stattfindet.

**8.** Verfahren nach einem der Ansprüche 2 bis 7, dadurch gekennzeichnet, daß beim Abtragsätzen und beim Plasma-unterstützten Ätzen mit lokaler Auflösung mindstens ein Fluor-haltiges Ätzgas zum Einsatz kommt und zumindest ein Teil der mit den Halbleiterscheiben reagierenden Neutralteilchen Fluorradikale sind.

**9.** Verfahren nach einem der Ansprüche 2 bis 8, dadurch gekennzeichnet, daß das Abtragsätzen im Vakuum durchgeführt wird und im Plasma Neutralteilchen durch Mikrowellenanregung erzeugt werden.

**10.** Verfahren nach einem der Ansprüche 2 bis 8, dadurch gekennzeichnet, daß das Abtragsätzen unter Atmosphärendruck durchgeführt wird und im Plasma Neutralteilchen durch thermische Anregung erzeugt werden.

**11.** Verfahren nach einem der Ansprüche 2 bis 10, dadurch gekennzeichnet, daß das Plasma-unterstützte Ätzen mit lokaler Auflösung im Vakuum durchgeführt wird und im Plasma Neutralteilchen durch Elektronenanregung erzeugt werden.

**12.** Verfahren nach einem der Ansprüche 2 bis 11, dadurch gekennzeichnet, daß beim Abtragsätzen Vorder- und Rückseiten der Halbleiterscheiben nacheinander geätzt werden.

**13.** Verfahren nach einem der Ansprüche 2 bis 12, dadurch gekennzeichnet, daß beim Plasma-unterstützten Ätzen mit lokaler Auflösung entweder auf den Vorderseiten oder auf den Rückseiten der Halbleiterscheiben geätzt wird.

**14.** Verfahren nach einem der Ansprüche 2 bis 13, dadurch gekennzeichnet, daß beim Einebnen 10-100 µm pro Scheibenseite von den Halbleiterscheiben geschliffen, beim Abtragsätzen 5-50 µm pro Scheibenseite und beim Plasma-unterstützten Ätzen mit lokaler Auflösung 0,5-5 µm pro Scheibenseite von den Halbleiterscheiben geätzt wird.

**15.** Verfahren nach einem der Ansprüche 2 bis 14, dadurch gekennzeichnet, daß die Halbeiterscheiben zwischen dem Abtragsätzen und dem Plasma-unterstützten Ätzen mit lokaler Auflösung einer Doppelseitenpolitur als zusätzlichem Verfahrensschritt unterzogen werden.

**16.** Verfahren nach Anspruch 15, dadurch gekennzeichnet, daß die Doppelseitenpolitur mit einem Poliertuch der Härte 40 bis 120 (Shore A) und einer Poliersole mit einem SiO₂-Feststoffgehalt von 1-10 Gew.-% und einem pH-Wert von 9-12 durchgeführt wird.

**17.** Verfahren nach Anspruch 15 oder Anspruch 16, dadurch gekennzeichnet, daß bei der Doppelseitenpolitur 5-50 µm Material pro Scheibenseite von den Halbleiterscheiben abgetragen wird.

**18.** Verfahren nach einem der Ansprüche 2 bis 17, dadurch gekennzeichnet, daß die Halbleiterscheiben nach einem der Verfahrensschritte einer Wärmebehandlung unterzogen werden.

**19.** Verfahren nach Anspruch 18, dadurch gekennzeichnet, daß die Wärmebehandlung bei einer Temperatur zwischen 400 °C und 800 °C zur Donor-Annihilation durchgeführt wird.

**20.** Verfahren nach Anspruch 18 oder Anspruch 19, dadurch gekennzeichnet, daß die Wärmebehandlung nach dem Abtragsätzen durchgeführt wird.

**21.** Verfahren nach Anspruch 18 oder Anspruch 19, dadurch gekennzeichnet, daß die Wärmebehandlung nach dem Plasmaunterstützten Ätzen mit lokaler Auflösung durchgeführt wird.

**22.** Verfahren nach einem der Ansprüche 2 bis 21, dadurch gekennzeichnet, daß die Halbleiterscheiben zwischen dem Schleifen und dem Abtragsätzen hydrophiliert werden.

**23.** Verfahren nach einem der Ansprüche 2 bis 22, dadurch gekennzeichnet, daß die Halbleiterscheiben zwischen dem Abtragsätzen und Plasma-unterstützten Ätzen mit lokaler Auflösung hydrophiliert werden.

**24.** Verfahren nach einem der Ansprüche 2 bis 23, dadurch gekennzeichnet, daß die Halbleiterscheiben zwischen dem Abtragsätzen und Plasma-unterstützten Ätzen mit lokaler Auflösung mit HF behandelt werden.

**25.** Verfahren nach einem der Ansprüche 2 bis 24, dadurch gekennzeichnet, daß vor dem Schleierfreipolieren eine Rückseitenpolitur durchgeführt wird.
